# EUROPEAN PATENT SPECIFICATION

(11) **EP 0 335 720 B1**
(45) Date of publication and mention of the grant of the patent: **26.07.1995**
(21) Application number: 89303158.3
(22) Date of filing: 30.03.1989
(51) Int. Cl.: H01L 29/72, H01L 29/08, H01L 29/10

(54) **Bipolar transistor device and method of manufacturing the same**
Bipolartransistor und Verfahren zu seiner Herstellung
Transistor bipolaire et procédé pour sa fabrication

(30) Priority: 30.03.1988 JP 74443/88
(43) Date of publication of application: 04.10.1989
(73) Proprietor: KABUSHIKI KAISHA TOSHIBA, Kawasaki-shi, Kanagawa-ken 210 (JP)
(72) Inventor: Morizuka, Kouhei c/o Patent Division K.K.Toshiba, Tokyo 105 (JP)
(74) Representative: Freed, Arthur Woolf

(56) References cited:
- EP-A- 0 297 886
- PROCEEDINGS IEEE/CORNELL CONFERENCE ON ADVANCED CNOCEPTS IN HIGH SPEED SEMICONDUCTOR DEVICES AND CIRCUITS, New York, 10th-12th August 1987, pages 274-283, IEEE, New York, US; M.A. RAO et al.: "A self-aligned AlGaAs/GaAs heterostructure bipolar transistor with non-alloyed graded-gap ohmic contacts to the base and emitter"
- ELECTRONICS LETTERS, vol. 24, no. 20, 29th September 1988, pages 1293-1294,Stevenage, Herts, GB; H. SCHUMACHER et al.: "High-speed self-aligned InP/GalnAs double heterostructure bipolar transistor with high current-driving capability"
- S. M. Sze: VLSI Technology; Mc Graw-Hill, 1983; p. 365

## Description

The present invention relates to a bipolar transistor device and a method of manufacturing the same.

Compared to a field effect transistor, a bipolar transistor has a greater current drive ability and a higher cutoff frequency. Thus, the bipolar transistor is suitable for use in a high-speed circuit. In order to realize a high-speed operation of the bipolar transistor, it is necessary to eliminate various parasitic resistance and capacitance as much as possible. In particular, the high-speed operation of the bipolar transistor can be realized by decreasing the base resistance in accordance with the reduction in emitter width, and by lowering the capacitance between a base and a collector in accordance with the reduction in base width and in collector width. From this viewpoint, various self-alignment techniques have been developed in the field of double diffused silicon transistors using polycrystalline silicon as materials of an emitter electrode and a base electrode. The self-alignment techniques have greatly contributed to the realization of high-speed operation. However, a drastic improvement in the self-alignment technique has now been unexpectable.

A high-speed transistor, which has recently attracted public attention, is one having a wide forbidden band gap. This transistor has an emitter whose forbidden band gap is wider than that of a base. Thus, even if a rate of base doping is increased, an emitter injection efficiency does not lower, and a base resistance is low. At present, this type of hetero-junction bipolar transistor (hereinafter, referred to as "HBT") is manufactured by an MBE (molecular beam epitaxy) method or an MOCVD (metal-organic chemical vapor deposition). An HBT has been developed which uses a Group III - V compound semiconductor of which an excellent hetero junction can be made. In the recent lithography technique, a minimum line width is nearly equal to a mask positioning tolerance. As in the case of a conventional transistor, a self-alignment technique for eliminating a mask positioning tolerance for the purpose of reduction in emitter width, base width and collector width has to be developed in the manufacture of the HBT. In the manufacture of the conventional transistor, a junction has been formed by a diffusion method, whereas in the manufacture of the HBT a junction is formed by an epitaxial growth method. Thus, the self-alignment technique developed in the manufacture of conventional transistors is not applicable to the manufacture of HBTs. It is necessary to devise a new self-alignment technique.

One of effective self-alignment methods applicable to the HBT is disclosed in IEEE ELECTRON DEVICE LETTERS, Vol. EDL-8, No. 7, July 1987, pp. 303-305. In this method, an inverse mesa structure is employed in an emitter, so that a base electrode may be separated from the emitter. Further, an SiO₂ film is formed on the base electrode and on a side wall of the emitter by an optical CVD method and a lift-off of a resist, whereby the emitter electrode is separated from the base electrode. However, in order to form the emitter region of the inverse mesa type, it is necessary to uniformly arrange emitter stripes in the (110) direction and to use such an etching liquid, in an etching step, as the etching rate in the (111) A plane is different from that in B plane. Consequently, high integration of the transistor is not possible. Also, in forming the SiO₂ film by the optical CVD method, it is difficult to thicken the SiO₂ film because of limitations to the shape of a mask. In fact, in the manufacture of a transistor, an emitter electrode projects above a base electrode owing to the difficulty in mask positioning. As a result, a capacitance having a thin SiO₂ film is formed between the emitter electrode and the base electrode, thereby preventing the improvement of high-speed transistor.

Furthermore, since the SiO₂ film is formed by the optical CVD method by using a resist film as a mask, the SiO₂ must be produced in a low temperature range, for example, 150°C or below, so that the resist film may not be hardened. The film formed in such a low temperature has a number of small pores and problems such as corrosion or defective insulation may occur. Thus, this method is undesirable in practical aspects.

On the other hand, according to a method of manufacturing a bipolar transistor disclosed in Japanese Patent Disclosure (Kokai) No. 61-117865, an insulation film is formed on a side wall of an emitter, thereby to separate the emitter from a base electrode. Further, an insulator layer is provided on the base electrode in order to separate an emitter electrode from the base electrode. This method includes various manufacturing steps and is troublesome. Since a separation layer for separating the emitter region from the base electrode and a separation layer for separating the base electrode from the emitter electrode are formed independently, troublesome steps are involved. Furthermore, the yield of products is not satisfactory in this method. These drawbacks are due to a reactive ion etching performed in forming the emitter. If the reactive ion etching is performed, a damage is caused in a junction face between the emitter and the base, and a recombination occurs. Consequently, a gain of the transistor is decreased. If an emitter is formed by a wet etching process and thereafter an SiO₂ film is deposited, the SiO₂ is not sufficiently filled in a space between a deformed emitter and a base electrode. Thus, small pores are left between the emitter and the base electrode, and a transistor having excellent characteristics cannot be obtained.

Japanese Patent Disclosure (Kokai) No. 61-82474 discloses a technique of reducing an emitter area. An insulation film having substantially the same height as an emitter region is formed on a base electrode provided on an external base region, thereby covering the vicinity of the emitter region with the insulation film. Thereafter, an emitter electrode is put in contact with the entire upper surface of the emitter region. Since the emitter region is sufficiently separated from the base electrode, any type of insulator substance, even if used, does not adversely affect the characteristics of the produced transistor. For this reason, Japanese Patent Disclosure (Kokai) No. 61-82474 pays no attention to the type of an insulation film and the method of manufacturing the insulation film. According to this prior art, though the emitter width can be reduced, it is difficult to reduce the base width and the collector width.

Since a Group V element has a high vapor pressure, there is no effective technique, at present, of desirably diffusing the element in a compound semiconductor. Thus, for achieving contact with a collector layer or the lowermost layer, it is necessary to expose the collector layer by etching. Consequently, a large stepped portion due to etching is produced in the vinicity of the collector electrode, and a problem such as a cutting in multi-layer wiring occurs.

Here, it can be noted that Proc. IEEE/Cornell Conf. Adv. Concepts High Speed Semicon.Dev. Ctts (1987) 274-283 describes a bipolar structure with an inverse mesa emitter structure and a resin layer formed on the base region exposed between the base electrode and the bottom portion of the emitter region.

A first object of the present invention is to provide a bipolar transistor device wherein the emitter width, base width and collector width are reduced.

A second object of this invention is to provide a bipolar transistor device functioning at high speed and having a high cutoff frequency.

A third object of the invention is to provide a bipolar transistor device having a high integration.

A fourth object of the invention is to provide a method of manufacturing the above-mentioned bipolar transistor devices.

A first bipolar transistor device of the present invention for achieving the above objects comprises a collector region of a first conductivity type formed on a semiconductor substrate, a base region of a second conductivity type formed on the collector region, an upwardly narrowing mesa type emitter region of the first conductivity type formed on the base region, a base electrode formed on the base region and separated from a bottom portion of the mesa type emitter region, a resin layer formed on the base electrode and covering the base region exposed between the base electrode and the bottom portion of the emitter region, and a side face of the emitter region, and an emitter electrode covering the entire upper surface of said emitter region and overlapping at its end portion with the base electrode with the resin layer being interposed.

According to this bipolar transistor device, the emitter region is surrounded by the resin layer. Though the width of the emitter region is reduced, the width of the emitter electrode can be increased; therefore, the emitter resistance can be decreased, and a short-circuit between the emitter electrode and the base electrode can be prevented.

A second bipolar transistor device of the present invention comprises a collector region of a first conductivity type formed on a semiconductor substrate, a base region of a second conductivity type formed on the collector region, an upwardly narrowing mesa type emitter region of the first conductivity type formed on the base region, a base electrode formed on the base region and separated from a bottom portion of the mesa type emitter region, a first resin layer formed on the base electrode and covering the base region exposed between the base electrode and the bottom portion of the emitter region, and a side face of the emitter region, an emitter electrode covering the entire upper surface of said emitter region and overlapping at its end portion with the base electrode with the resin layer being interposed, a collector electrode formed on the collector region, and a second resin layer of the same type as the first resin layer, the second resin layer being provided on the collector electrode.

In a first method of manufacturing the bipolar transistor device of the present invention, a first semiconductor layer of a first conductivity type, a second semiconductor layer of a second conductivity type and a third semiconductor layer of the first conductivity type are sequentially laminated on a semiconductor substrate, and a collector electrode, a base electrode and an emitter electrode are formed on the first to third semiconductor layers, respectively. This method comprises a step of forming a first mask material for forming an emitter region and a second mask material for forming a base electrode, on the third semiconductor layer in this order, a step of forming a base electrode pattern on the second mask material and forming a pattern wider than the base electrode pattern on the first mask material, a step of performing an etching until the second semiconductor layer is exposed by using the first mask material as a mask, thereby to form an upwardly narrowing mesa-type emitter region, a step of depositing a metal by using the second mask material as a mask, thereby to form a base electrode on the exposed second semiconductor layer, a step of removing the second mask material, a step of forming a planarising resin layer over the entire exposed surface of the resultant structure after the second mask is removed, a step of subjecting the formed resin layer to an etching, until the first mask material is exposed, a step of removing the first mask material exposed by the etching step and exposing the third semiconductor layer, and a step of forming an emitter electrode on the entire exposed third semiconductor layer.

In this method, the first mask material for forming the emitter region and the second mask material for forming the base electrode are laminated, in this order, on the third semiconductor layer which will become the emitter. A hole, which is larger than a hole formed in the second mask material, is formed in the first mask material. By etching the third semiconductor layer with use of the first mask material, the second semiconductor layer can be exposed in an area larger than the width of the hole in the second mask material. The width of the base electrode formed on the exposed second semiconductor layer is determined by the width of the hole in the second mask material. As stated above, the width of the exposed second semiconductor layer is greater than that of the hole in the first mask material, the emitter region can be separated from the base electrode in a self-alignment manner.

In the present invention, the manufacturing steps are simplified, and it is not necessary to provide a mask positioning tolerance in forming the emitter electrode and the base electrode. Since it is possible to decrease the base resistance as a result of reduction in emitter width and to decrease the capacitance between the base and the collector as a result in reduction of base width and collector width, the operation speed of the bipolar transistor can be increased, and the cutoff frequency of the bipolar transistor can be made higher. In addition, since there is no need to employ an inverse mesa structure in the emitter, it is not necessary to suitably arrange emitter stripes, so that high integration is possible.

In the method of the present invention, since the self-alignment technique using a resin layer is adopted, a positioning tolerance need not be provided in the emitter region for alignment between the base electrode and the emitter electrode. As a result, the size of the bipolar transistor can be reduced. Thus, the cutoff frequency of the transistor can be made higher, and the operation speed of the circuit can be increased.

In a second method of the present invention, a first semiconductor layer of a first conductivity type, a second semiconductor layer of a second conductivity type and a third semiconductor layer of the first conductivity type are sequentially laminated on a semiconductor substrate, and a collector electrode, a base electrode and an emitter electrode are formed on the first to third semiconductor layers, respectively. This method comprises a step of forming a first mask material for forming an emitter region and a second mask material for forming a base electrode, on the third semiconductor layer in this order, a step of forming a base electrode pattern on the second mask material and forming a pattern wider than the base electrode pattern on the first mask material, a step of performing an etching until the second semiconductor layer is exposed by using the first mask material as a mask, thereby to form an upwardly narrowing mesa-type emitter region, a step of depositing a first metal by using the second mask material as a mask, thereby to form a base electrode on the exposed second semiconductor layer, a step of removing the second mask material, a step of forming a third mask material after the step of removing the second mask material, a step of forming a collector electrode forming pattern on the third mask material and etching the first mask material, a step of etching the third semiconductor layer and the second semiconductor layer by using the first mask material as a mask, until the first semiconductor layer is exposed, a step of depositing a second metal with use of the third mask material as a mask to form a collector electrode on the exposed first semiconductor layer, a step of removing the third mask material, a step of forming a planarising resin layer over the entire exposed surface of the resultant structure after the third mask is removed, a step of subjecting the formed resin layer to an etching, until the first mask material is exposed, a step of removing the first mask material exposed by the etching step to expose the third semiconductor layer, and a step of forming an emitter electrode on the entire exposed third semiconductor layer.

In the second method of the present invention, the resin layer is left on the collector electrode, and the wafer surface is flattened. Thus, an upper layer electrode can be formed above the collector electrode.

The material of the resin layer used in the invention is not limited, however, polyimide is desirable.

In the invention, the distance between the base electrode and the emitter region is defined, depending on the kind of semiconductor material used in the base region, the doping concentration of impurity, the kind of material of the electrode, conditions in the process, etc. In a general alloy step using AuZn, performed at 350°C, a metal enters into the base region by 0.05 »m. Thus, in order to prevent a short-circuit between the emitter and the base, the base electrode must be separated from the emitter region by 0.05 »m or more. If the base electrode is separated from the emitter region by 0.5 »m or more, the merit due to self-alignment cannot be obtained, and the base width and collector width cannot be reduced.

Other objects and advantages will be apparent from the following description taken in conjunction with the accompanying drawings in which:
Fig. 1 is a cross sectional perspective view showing a bipolar transistor device according to a first embodiment of the present invention;
Figs. 2A to 2L show a process of manufacturing the bipolar transistor according to the first embodiment;
Fig. 3 shows the relationship between the collector current density and the current amplification factor;
Fig. 4 is a cross sectional perspective view showing a bipolar transistor device according to a second embodiment of the present invention;
Figs. 5A to 5L show a process of manufacturing the bipolar transistor device according to the second embodiment;
Fig. 6 shows the relationship between the collector current density and the maximum oscillation frequency;
Figs. 7A and 7B show layouts of the bipolar transistor device of the present invention;
Fig. 8A shows an example of the layout of the bipolar transistor device;
Fig. 8B shows is a cross section taken along line VIIIB - VIIIB of Fig. 8A;
Fig. 9A shows an example of the layout of the bipolar transistor device;
Fig. 9B is a cross section taken along line IXB - IXB of Fig. 9A;
Fig. 10A shows a layout of the bipolar transistor device of the invention; and
Fig. 10B is a cross section taken along line XB - XB of Fig. 10A.

A description will now be given of an HBT (hetero-junction bipolar transistor) using a hetero-junction of GaAs and AℓGaAs, according to a first embodiment of the invention, and a manufacturing method thereof.

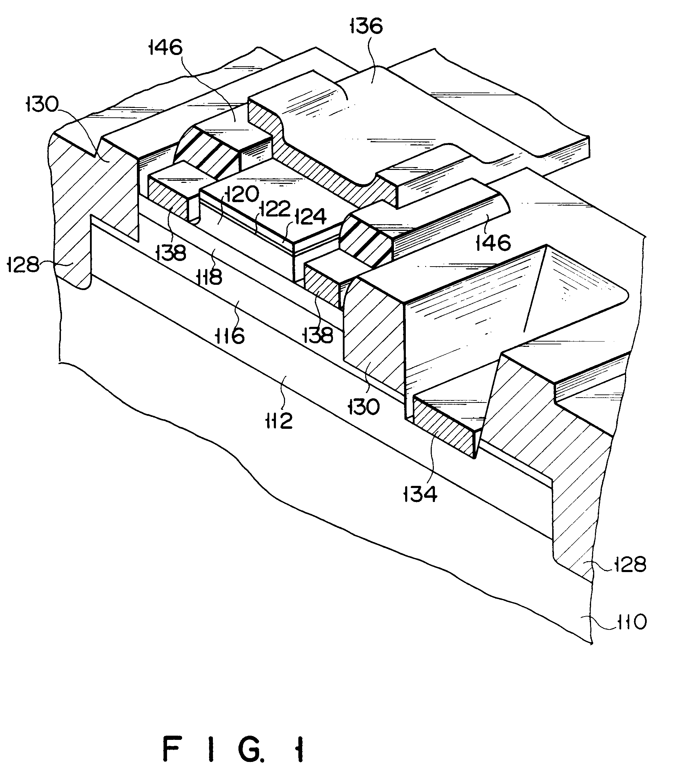

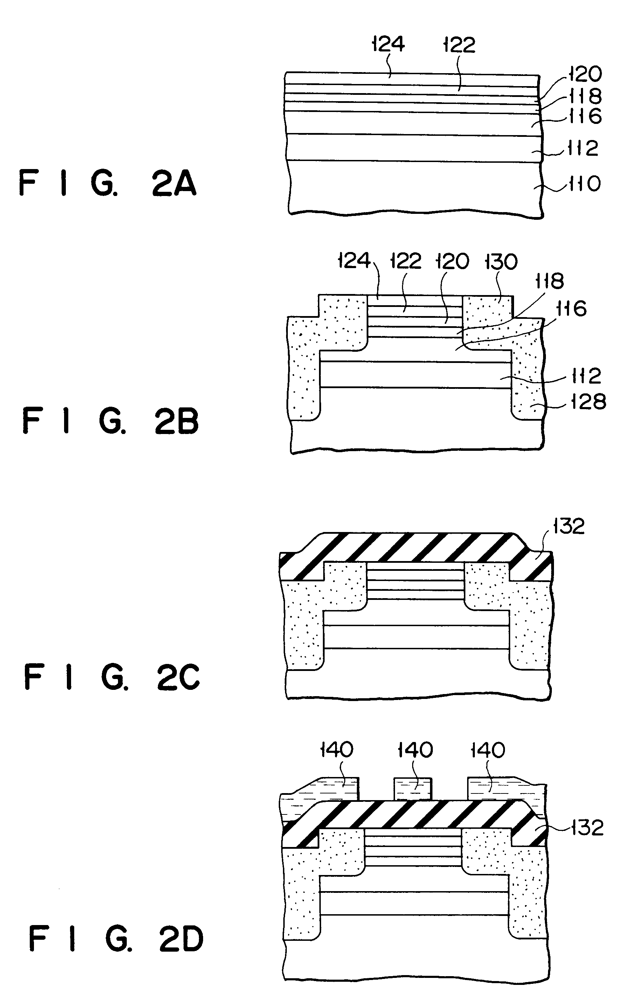

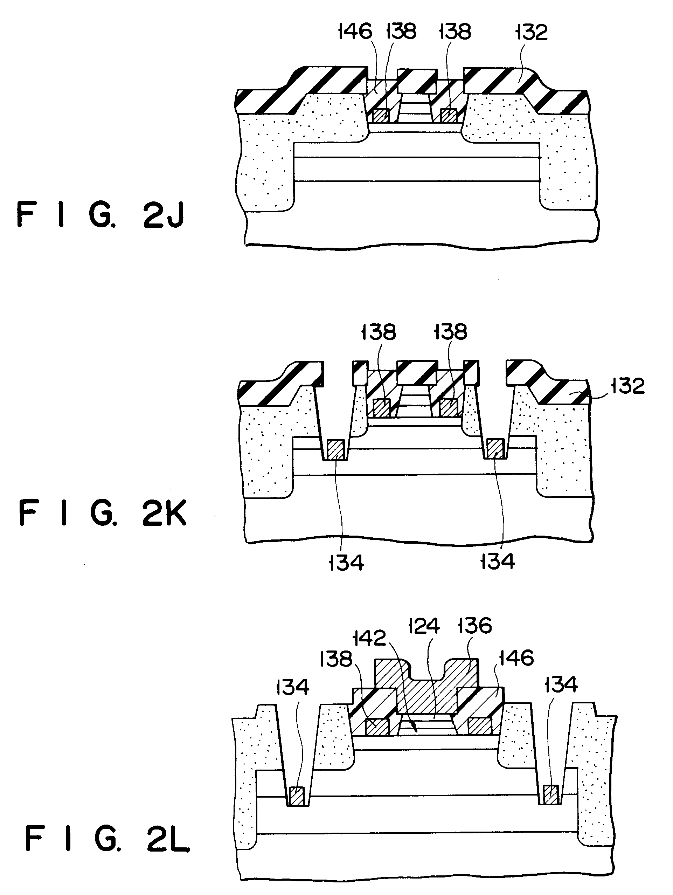

An HBT as shown in Fig. 1 is manufactured by steps shown in Figs. 2A to 2L.

As shown in Fig. 2A, a buried n⁺GaAs collector layer 112 having a thickness of 0.5 »m is formed on semi-insulating GaAs substrate 110. An n⁻GaAs collector layer 116 having a thickness of 0.5 »m and a carrier density of 5 × 10¹⁶ cm⁻³ is formed on collector layer 112. An p⁺GaAs base layer 118 having a thickness of 0.1 »m and a carrier density of 3 × 10¹⁹ cm⁻³ is formed on collector layer 116. An n⁻Aℓ_{0.25}Ga_{0.75}As emitter layer 120 having a thickness of 0.1 »m and a carrier density of 5 × 10¹⁷ cm⁻³ is formed on base layer 118. An n⁺AℓGaInAs layer 122 having a thickness of 0.05 »m and a carrier density of 1 × 10¹⁹ cm⁻³ is formed on emitter layer 120. An n⁻Ga_{0.5}In_{0.5}As layer 124 having a thickness of 0.05 »m and a carrier density of 1 × 10¹⁹ cm⁻³ is formed on AℓGaInAs layer 122. These layers are formed by the MBE method. The composition of AℓGaInAs layer 122 is determined such that the composition of Aℓ_{0.25}Ga_{0.75}As layer 120 is gradually changed to the composition of In_{0.5}Ga_{0.5}As layer 124 by gradually decreasing the ratio of Aℓ and Ga and increasing the ratio of In.

As shown in Fig. 2B, high-resistance region 128 for separating elements and high-resistance region 130 for base/collector separation are formed by proton injection. In this case, a mask made of, for example, polyimide, which is used in forming high-resistance region 128, is also used as an etching mask for selectively etching GaInAs layer 124 and AℓGaInAs layer 122. The reason for performing this step is that the resistance of layers 122 and 124 cannot be sufficiently increased by the proton implantation, for the forbidden band gap between layers 122 and 124 is narrow.

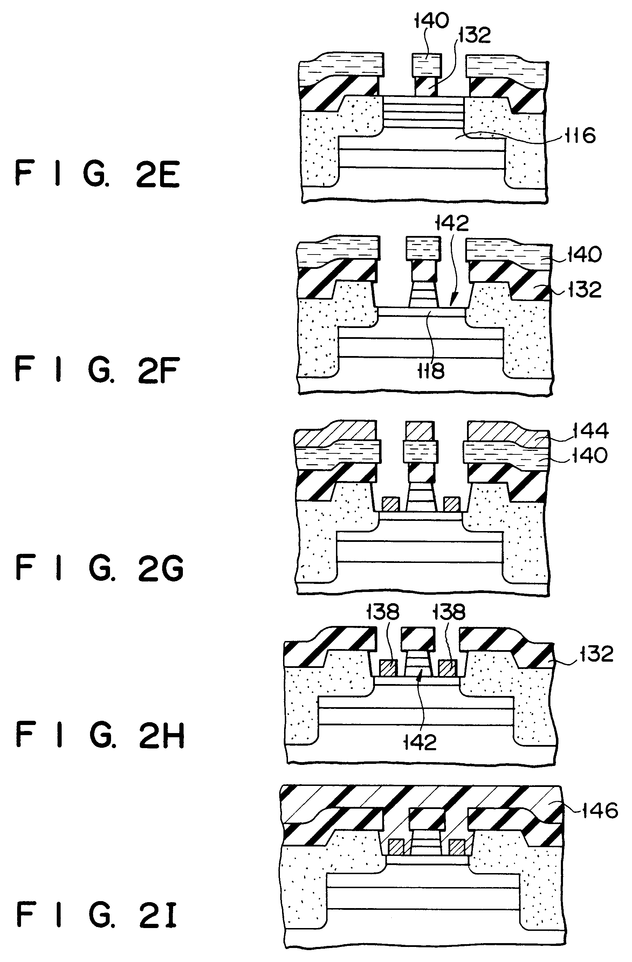

In Fig. 2C, SiO₂ film 132 having a thickness of 0.5 »m is deposited over the surface of the wafer by the CVD (chemical vapor deposition) method. As shown in Fig. 2D, photoresist pattern 140 for forming a base electrode is formed on SiO₂ film 132. As shown in Fig. 2E, SiO₂ film 132 is etched by the RIE method, with use of photoresist pattern 140 as a mask, and also the side etching of SiO₂ film is performed by wet etching.

By using SiO₂ film 132 as a mask, GaInAs layer 124, AℓGaInAs layer 122 and emitter layer 120 are removed by wet etching, so that base layer 118 is exposed. In this step, the size of emitter region 142 is defined. Then, as shown in Fig. 2G, AuZn alloy 144 is deposited over the surface of the wafer. Fig. 2H shows the state wherein photoresist 140 is melted and base electrode 138 is formed by lift-off method. In the etching steps shown in Figs. 2E and 2F, SiO₂ film 132 is side-etched in relation to photoresist 140, and emitter region 142 is side-etched in relation to SiO₂ film 132. Since the distance between emitter region 142 and base electrode 138 is defined by the degree of the side etching, this distance can be made very narrow, for example, 0.1 »m to 0.2 »m.

As shown in Fig. 2I, prepolymer solution formed of polyimide resin is coated over the surface of the wafer by a spin-coating method, and the prepolymer solution is gradually heated up to 320°C, thereby to form polyimide resin layer 146. Then, as shown in Fig. 2J, polyimide resin layer 146 is etched in a plasma using a gas mixture of oxygen and CF₄ until SiO₂ film 132 is exposed. In the step of Fig. 2I, the surface of polyimide resin 146 is flattened because of the viscosity of the prepolymer solution. Thus, polyimide resin 146 remains on base electrode 138.

In the same manner as shown in Figs. 2F to 2H, collector electrode 134 formed of an AuGeNi alloy is formed, as shown in Fig. 2K. The semiconductor structure is heated at 360°C in the presence of argon gas, base electrode 138 made of AuZn and collector electrode 134 made of AuGeNi are alloyed with GaAs, so that an ohmic contact is obtained.

As shown in Fig. 2L, SiO₂ film 132 is melted and removed with the use of a mixture solution of ammonium fluoride and a fluoric acid, thus exposing emitter layer 124. In this step, a naturally oxidized film on the surface of the GaInAs layer 124 is also removed, thereby obtaining a good ohmic contact of the emitter. When an SiO₂ film frequently used in a conventional method is substituted for polyimide resin layer 146 and used as a cover layer for the base electrode, it is impossible to take a surface pretreatment of GaInAs layer 124 using ammonium fluoride. This is because the SiO₂ film may be etched by ammonium fluoride.

Emitter contact 136 made of Ti/Pt/Au is provided on the exposed emitter layer 124 by a lift-off method. In this case, the pattern of emitter electrode 136 is greater than emitter region 142 by 0.5 »m. Polyimide resin 146, which surrounds emitter region 142, prevents emitter electrode 136 from being short-circuited with base electrode 138. In addition, since a positioning allowance of emitter electrode 136 is provided outside of emitter region 142, the emitter width can be reduced irrespective of the positioning allowance. In this embodiment, the emitter width is 1.5 »m. Since the base electrode width is set to 1 »m, the base/collector width can be reduced to 3.5 »m. In the case of a conventional mesa-type transistor, if the minimum line width and minimum positioning allowance would be set to 1 »m, the emitter width becomes 3 »m and the base/collector width becomes 7 »m. In the case of the transistor of this embodiment, these widths are half, compared to the conventional transistor.

According to this embodiment, there is no need to consider the positioning allowance between the emitter region, and the base electrode and the emitter electrode. Thus, the size of the element can be reduced to about half, compared to the prior art. As a result, the cutoff frequency of the transistor can be increased, and the operation speed of the circuit can be raised. In the structure of the embodiment, the transit time of electrons from the emitter to the collector is 2 ps, and the limit value of the cutoff frequency is 80 GHz. In the transistor whose base/collector width is 3.5 »m, a nearly maximum limit value of the cutoff frequency of 75 GHz is obtained. This is because the size of the element is reduced, and the base/collector capacitance and the collector resistance are reduced to half the values of the conventional device. Thus, the present invention is effective in improving the high-frequency characteristic of the transistor. If the self-alignment technique of the present invention is used, an error in the mask positioning can be eliminated, and the uniformity of elements can be improved, resulting in high integration of the elements.

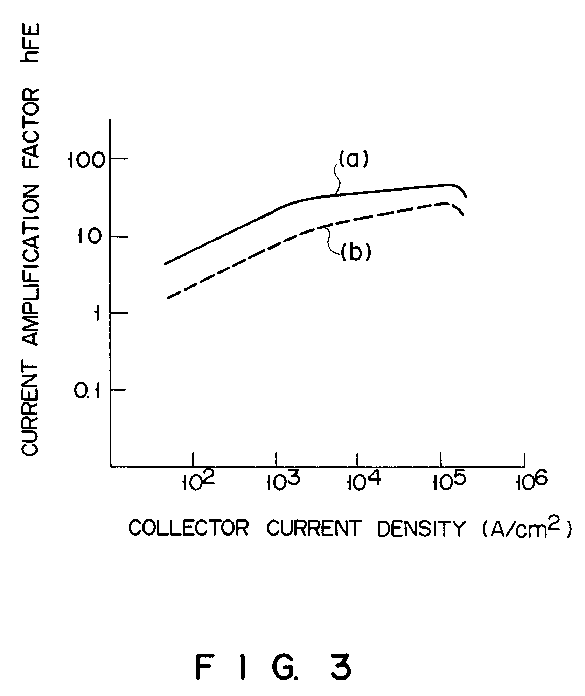

As a comparative example, a bipolar transistor was manufactured, which has the same structure as the present invention, has the emitter area of 1 »m × 3»m, and has an SiO₂ film formed by an optical CVD method, in place of a polyimide film. Also, a bipolar transistor device according to a second embodiment of the invention, which has the same emitter area as the comparative example and employs the element of the present invention (in which a polyimide resin layer is used) was manufactured. Fig. 3 shows the relationship between the second embodiment and the comparative example with respect to the collector current density and the current amplification factor. Line (a) indicates the second embodiment, and line (b) indicates the comparative example. Compared to the comparative example wherein the SiO₂ film was used for separating the emitter electrode and the base electrode, the transistor of the second embodiment, wherein the polyimide layer was used, has 1.5 times of the current amplification factor. In the comparative example, a stress is caused by the coating of the SiO₂ layer and a considerable number of recombination centers are produced in an emitter/base interface, resulting in a reduction in current amplification factor. In the second embodiment, the occurrence of a stress is suppressed, the number of recombination centers is reduced, thus improving the current amplification factor.

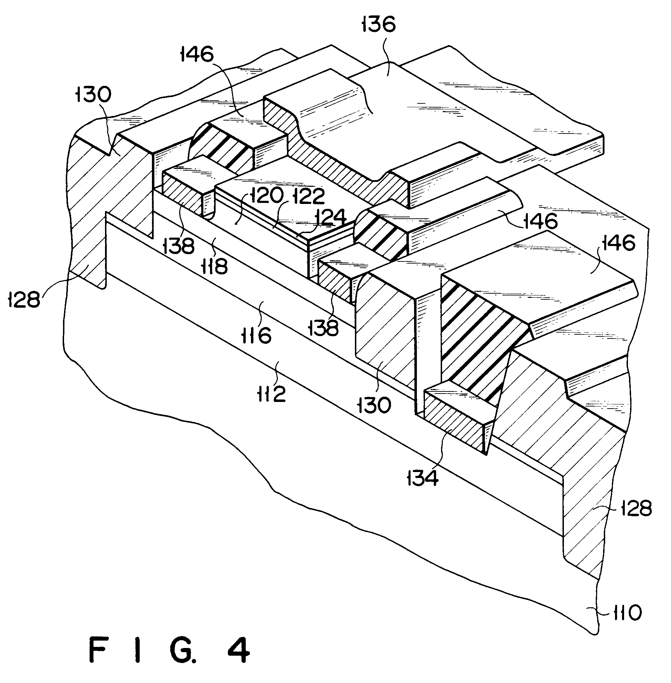

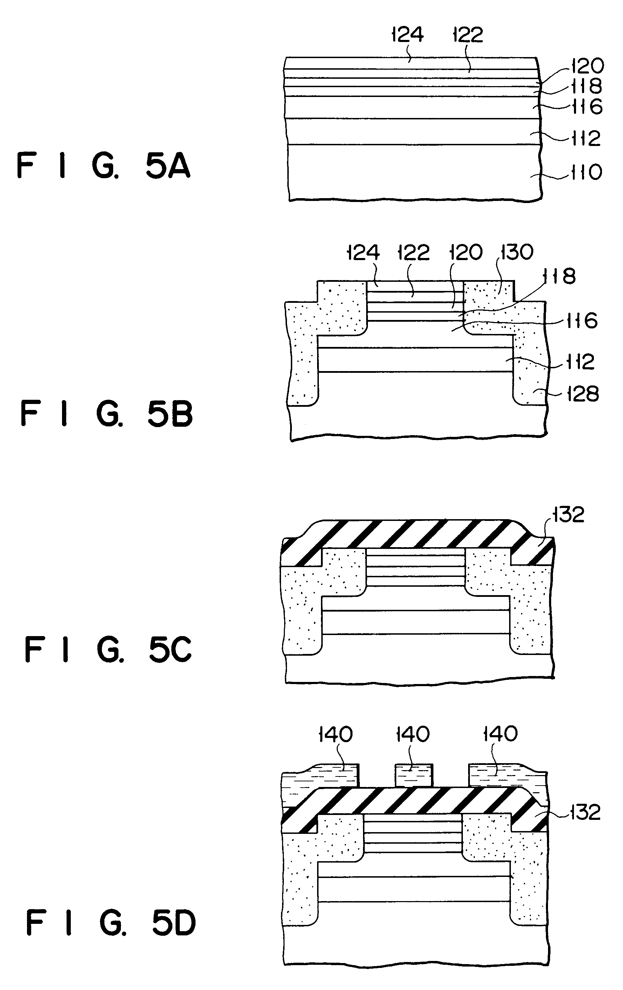

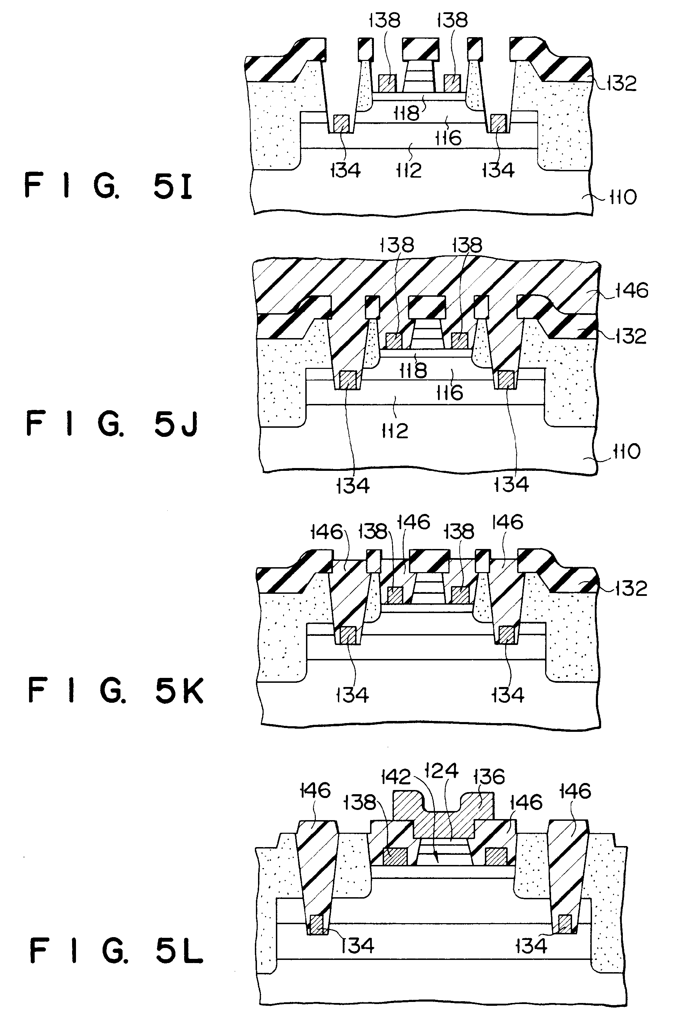

The bipolar transistor transistor device according to the third embodiment and a manufacturing process thereof will now be described with reference to Fig. 4 and Figs. 5A to 5L.

An HBT (hetero-junction bipolar transistor) as shown in Fig. 4 was manufactured by the steps shown in Figs. 5A to 5L.

As shown in Fig. 5A, a buried n⁺GaAs collector layer 112 having a thickness of 0.5 »m is formed on semi-insulating GaAs substrate 110. An n⁻GaAs collector layer 116 having a thickness of 0.5 »m and a carrier density of 5 × 10¹⁶ cm⁻³ is formed on collector layer 112. An p⁺GaAs base layer 118 having a thickness of 0.1 »m and a carrier density of 3 × 10¹⁹ cm⁻³ is formed on collector layer 116. An n⁻Aℓ_{0.25}Ga_{0.75}As emitter layer 120 having a thickness of 0.1 »m and a carrier density of 5 × 10¹⁷ cm⁻³ is formed on base layer 118. An n+AℓGaInAs layer 122 having a thickness of 0.05 »m and a carrier density of 1 × 10¹⁹ cm⁻³ is formed on emitter layer 120. An n⁻Ga_{0.5}In_{0.5}As layer 124 having a thickness of 0.05 »m and a carrier density of 1 × 10¹⁹ cm⁻³ is formed on AℓGaInAs layer 122. These layers are formed by the MBE method. The composition of AℓGaInAs layer 122 is determined such that the composition of Aℓ_{0.25}Ga_{0.75}As layer 120 is gradually changed to the composition of In_{0.5}Ga_{0.5}As layer 124 by gradually decreasing the ratio of Aℓ and Ga and increasing the ratio of In.

As shown in Fig. 5B, high-resistance region 128 for separating elements and high-resistance region 130 for base/collector separation are formed by proton implantation. In this case, a mask made of, for example, polyimide, which is used in forming high-resistance region 128, is also used as an etching mask for selectively etching GaInAs layer 124 and AℓGaInAs layer 122. The reason for performing this step is that the resistance of layers 122 and 124 cannot be sufficiently increased by the proton implantation, for the forbidden band gap between layers 122 and 124 is narrow.

In Fig. 5C, SiO₂ film 132 having a thickness of 0.5 »m is deposited over the surface of the wafer by the CVD (chemical vapor deposition) method. As shown in Fig. 5D, photoresist pattern 140 for forming a base electrode is formed on SiO₂ film 132. As shown in Fig. 5E, SiO₂ film 132 is etched by the RIE method, with use of photoresist pattern 140 as a mask, and also the side etching of SiO₂ film is performed by wet etching.

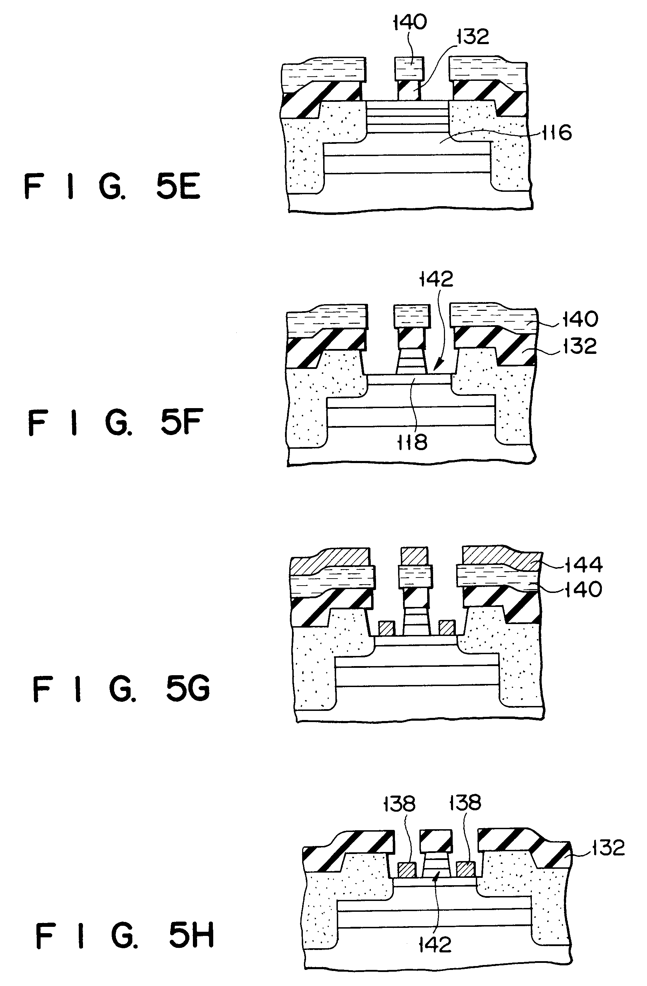

As shown in Fig. 5F, by using SiO₂ film 132 as a mask, GaInAs layer 124, AℓGaInAs layer 122 and emitter layer 120 are removed by wet etching, so that base layer 118 is exposed. In this step, the size of emitter region 142 is determined. Then, as shown in Fig. 5G, AuZn alloy 144 is deposited over the surface of the wafer. Fig. 5H shows the state wherein photoresist 140 is melted and base electrode 138 is formed by lift-off method. In the etching steps shown in Figs. 5E and 5F, SiO₂ film 132 is side-etched in relation to photoresist 140, and emitter region 142 is side-etched in relation to SiO₂ film 132. Since the distance between emitter region 142 and base electrode 138 is determined by the degree of the side etching, this distance can be made very narrow, for example, 0.1 »m to 0.2 »m.

After base electrode 138 is formed by lift-off, the wafer is dipped in an ammonium sulfide solution in order to stabilize the AℓGaAs surface of the emitter/base interface. It is considered that the interface is stabilized because sulfur in the solution makes the dangling bond of Aℓ or Ga inactive. By this treatment, the surface recombination rate is lowered, and the current gain is increased. If the transistor is left in the air, a sulfur compound is decomposed owing to the influence of moisture, and the effect of the surface treatment is lost. However, in the second embodiment, the surface, immediately after the surface treatment, is protected by a polyimide layer. Thus, the influence of moisture can be eliminated, and the effect of the surface treatment can be maintained semipermanently.

In the same manner as shown in Figs. 5F to 5H, collector electrode 134 formed of an AuGeNi alloy is formed, as shown in Fig. 5I. The semiconductor structure is heated at 360°C in the presence of argon gas, base electrode 138 made of AuZn and collector electrode 134 made of AuGeNi are alloyed with GaAs, so that an ohmic contact is obtained.

As shown in Fig. 5J, prepolymer solution formed of polyimide resin is coated over the surface of the wafer by a spin-coating method, and the prepolymer solution is gradually heated up to 320°C, thereby to form polyimide resin layer 146. Then, as shown in Fig. 5K, polyimide resin layer 146 is etched in a plasma using a gas mixture of oxygen and CF₄ until SiO₂ film 132 is exposed. In the step of Fig. 5J, the surface of polyimide resin 146 is flattened because of the viscosity of the prepolymer solution. Thus, polyimide resin remains on base electrode 138 and collector electrode 134.

As shown in Fig. 5L, SiO₂ film 132 is melted and removed with the use of a mixture solution of ammonium fluoride and a fluoric acid, thus exposing emitter layer 124. Emitter contact 136 made of Ti/Pt/Au is provided on the exposed emitter layer 124 by a lift-off method. In this case, the pattern of emitter electrode 136 is greater than emitter region 142 by 0.5 »m. Polyimide resin 146, which surrounds emitter region 142, prevents emitter electrode 136 from being short-circuited with base electrode 138. In addition, since a positioning allowance of emitter electrode 136 is provided outside of emitter region 142, the emitter width can be reduced irrespective of the positioning allowance. In this embodiment, the emitter width is 1.5 »m. Since the base electrode width is set to 1 »m, the base/collector width can be reduced to 3.5 »m. In the case of a conventional mesa-type transistor, if the minimum line width and minimum positioning allowance would be set to 1 »m, the emitter width becomes 3 »m and the base/collector width becomes 7 »m. In the case of the transistor of this embodiment, these widths are half, compared to the conventional transistor.

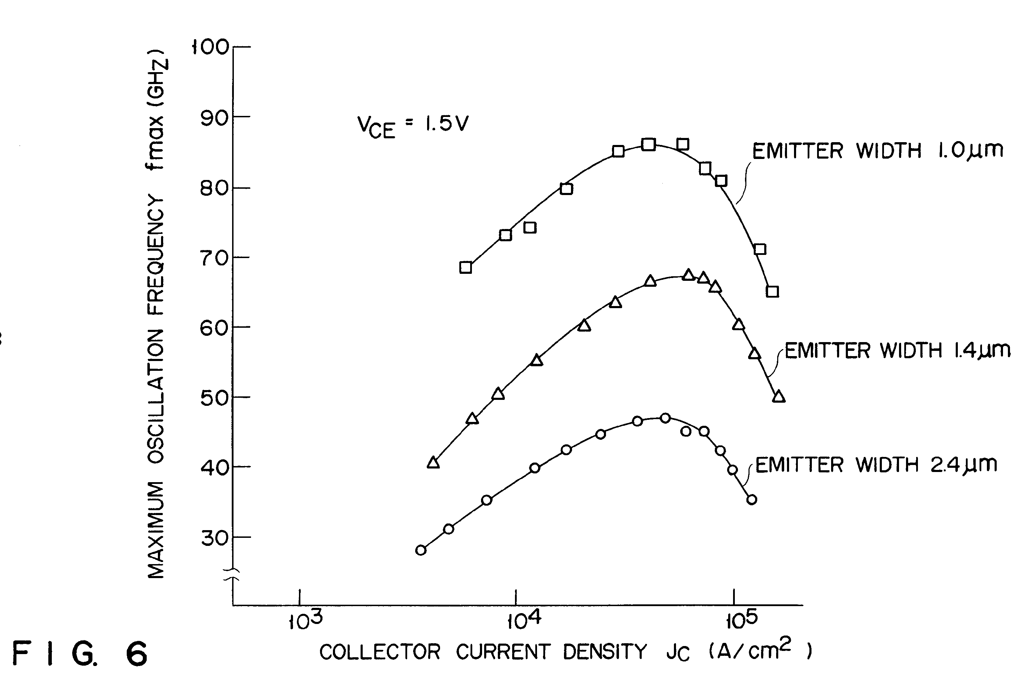

Fig. 6 shows the relationship between a maximum oscillation frequency and a collector current density in the transistor according to the third embodiment of the invention. As the emitter width is reduced from 2.4 »m to 1.0 »m, the maximum oscillation frequency is improved from 46 GHz to 86 GHz. This shows the advantage of the third embodiment.

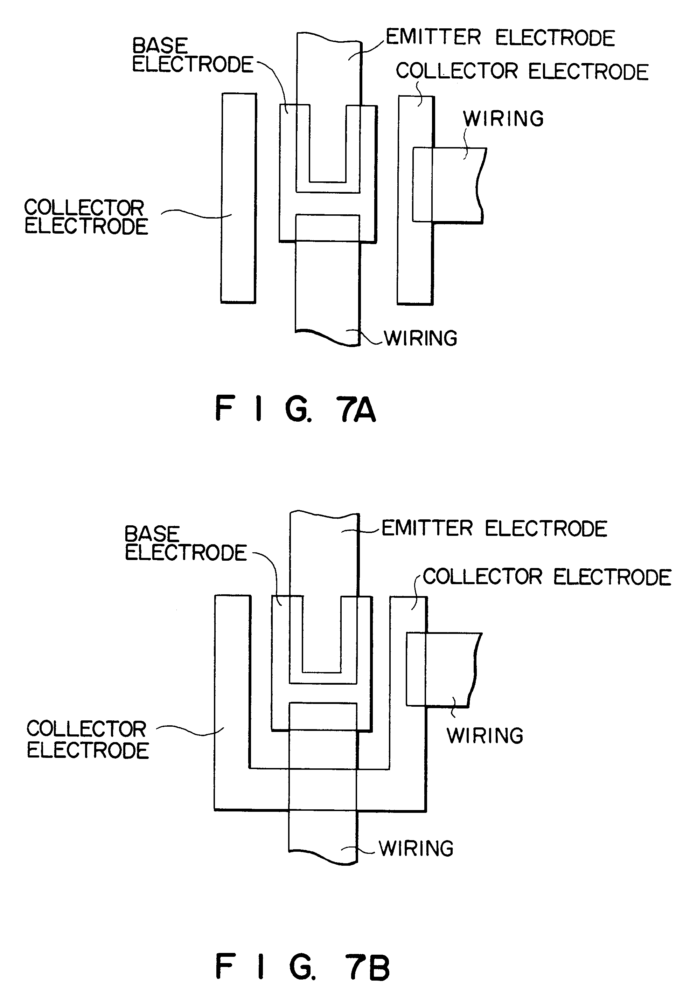

Since the upper surface of collector electrode 134 is flattened by polyimide, it is easy to cross wiring above collector electrode 134. If only a first layer wiring is employed, as shown in Fig. 7A, it is difficult to adopt a double collector structure. In the third embodiment of the invention, as shown in Fig. 7B, wiring can be provided after collector electrodes are mutually coupled. Thus, the double collector structure can be easily employed. As a result, the collector resistance can be reduced. In addition, the structure and process of the third embodiment are effective for high integration.

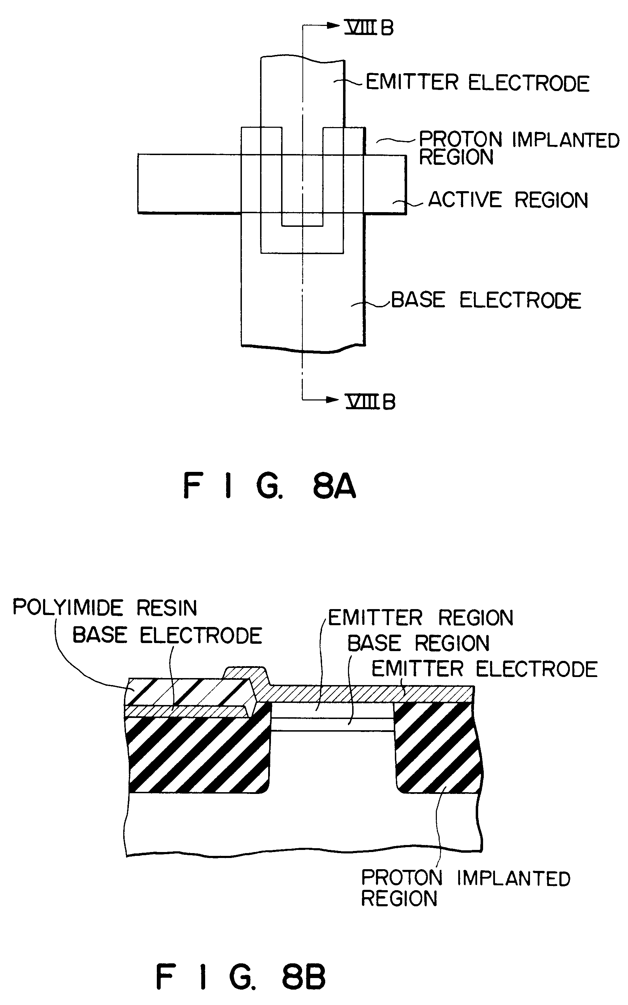

In the embodiment shown in Figs. 4 to 7, in order to draw the emitter electrode out of the transistor, the resistance of the side face of the emitter is increased by ion implantation. This structure is illustrated in Figs. 8A and 8B. With this structure, though the drawing out of the emitter electrode is easy, a number of crystalline defects are caused by proton implantation in the emitter/base interface. Thus, as the length of the emitter is reduced, undesirable phenomena such as lowering in current gain may occur. In a typical example, when the emitter length is 2 »m, the current gain is lower than 10.

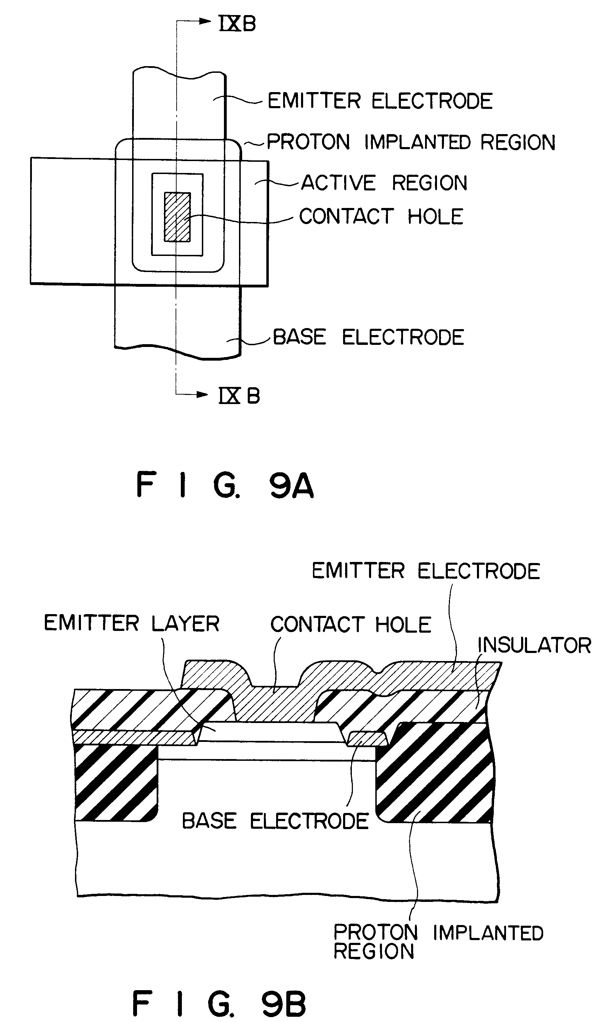

To deal with this problem, Fig. 9A proposes a pattern with which the emitter region can be defined by etching. Fig. 9B is a cross section taken along line IXB-IXB of Fig. 9A. With this structure, the emitter/base interface can be separated from the proton implantation region. However, in order to draw the emitter electrode out of the transistor, it is necessary to cover the base electrode with an insulation film and to make a contact hole on the emitter region. It is thus necessary to consider a positioning allowance for the contact hole in determining the size of the emitter region. As a result, the emitter width cannot be sufficiently reduced.

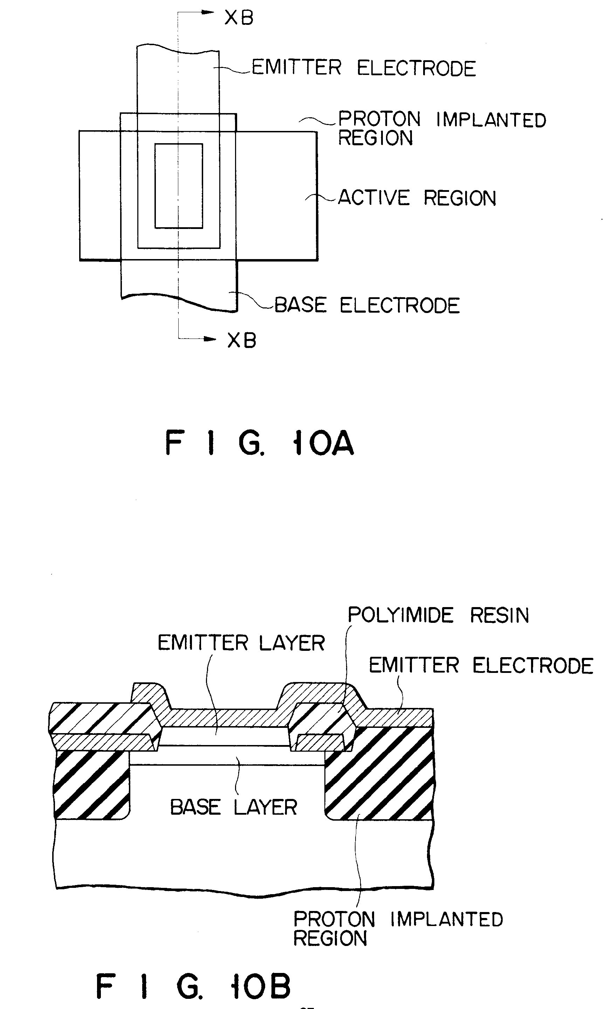

On the other hand, according to the structure shown in Figs. 10A and 10B, polyimide is left on the base electrode. Thus, the emitter electrode can be drawn out of the emitter region without providing the contact hole, and the emitter length can be easily reduced. In addition, since the emitter/base interface is separated from the proton implantation region, drawbacks such as lowering in current gain do not occur. In a typical example, when the emitter length is 2 »m and the emitter width is 1 »m, the current gain of the transistor is about 80. Therefore, the emitter region can be reduced in size, and simultaneously the good characteristic of the transistor can be maintained.

## Claims

1. A bipolar transistor device comprising:
a collector region (112, 116) of a first conductivity type formed on a semiconductor substrate;
a base region (118) of a second conductivity type formed on the collector region;
an upwardly narrowing mesa type emitter region (120, 122, 124) of the first conductivity type formed on the base region;
a base electrode (138) formed on the base region and separated from a bottom portion of the mesa type emitter region;
a resin layer (146) formed on the base electrode and covering the base region exposed between the base electrode and the bottom portion of the emitter region, and a side face of the emitter region; and
an emitter electrode (136) covering the entire upper surface of said emitter region and overlapping at its end portion with the base electrode with the resin layer being interposed.

2. The device according to claim 1, characterized in that said resin layer is a polyimide resin layer.

3. The device according to claim 1, characterized in that said resin layer is formed in a higher position than said emitter region.

4. The device according to claim 1, characterized in that a distance between the bottom portion of the emitter region and the base electrode is 0.05 to 0.5 »m.

5. A bipolar transistor device comprising:
a collector region (112, 116) of a first conductivity type formed on a semiconductor substrate;
a base region (118) of a second conductivity type formed on the collector region;
an upwardly narrowing mesa type emitter region (120, 122, 124) of the first conductivity type formed on the base region;
a base electrode (138) formed on the base region and separated from a bottom portion of the mesa type emitter region;
a first resin layer (146) formed on the base electrode and covering the base region exposed between the base electrode and the bottom portion of the emitter region, and a side face of the emitter region;
an emitter electrode (136) covering the entire upper surface of said emitter region and overlapping at its end portion with the base electrode with the resin layer being interposed;
a collector electrode (134) formed on the collector region; and
a second resin layer (146) of the same type as the first resin layer, the second resin layer being provided on the collector electrode.

6. The device according to claim 5, characterized in that said first and second resin layers provided on the base electrode and the collector electrode are polyimide resin layers, and these resin layers are located substantially at the same level.

7. A method of manufacturing a bipolar transistor device, wherein a first semiconductor layer (112, 116) of a first conductivity type, a second semiconductor layer (118) of a second conductivity type and a third semiconductor layer (120, 122, 124) of the first conductivity type are sequentially laminated on a semiconductor substrate, and a collector electrode (134), a base electrode (138) and an emitter electrode (136) are formed on the first to third semiconductor layers, respectively, said method comprising the steps of:
forming a first mask material (132) for forming an emitter region and a second mask material (140) for forming a base electrode, on the third semiconductor layer (120, 122, 124) in this order;
forming a base electrode pattern on the second mask material and forming a pattern wider than the base electrode pattern on the first mask material;
performing an etching until the second semiconductor layer (118) is exposed by using the first mask material as a mask, thereby to form an upwardly narrowing mesa-type emitter region (142);
depositing a metal by using the second mask material as a mask, thereby to form a base electrode (138) on the exposed second semiconductor layer;
removing the second mask material (140);
forming a planarising resin layer (146) over the entire exposed surface of the resultant structure after the second mask is removed;
subjecting the formed resin layer to an etching, until the first mask material (132) is exposed;
removing the first mask material (132) exposed by the etching step and exposing the third semiconductor layer (124), and
forming an emitter electrode (136) on the entire exposed third semiconductor layer.

8. The method according to claim 7, characterized in that said first, second and third semiconductor layers are formed by an epitaxial growth method.

9. The method according to claim 7, characterized in that, before the emitter electrode is formed, the semiconductor structure is subjected to a pretreatment using ammonium fluoride.

10. A method of manufacturing a bipolar transistor device, wherein a first semiconductor layer (112, 116) of a first conductivity type, a second semiconductor layer (118) of a second conductivity type and a third semiconductor layer (120, 122, 124) of the first conductivity type are sequentially laminated on a semiconductor substrate, and a collector electrode (134), a base electrode (138) and an emitter electrode (136) are formed on the first to third semiconductor layers, respectively, said method comprising the steps of:
forming a first mask material (132) for forming an emitter region and a second mask material (140) for forming a base electrode, on the third semiconductor layer (120, 122, 124) in this order;
forming a base electrode pattern on the second mask material and forming a pattern wider than the base electrode pattern on the first mask material;
performing an etching until the second semiconductor layer (118) is exposed by using the first mask material (132) as a mask, thereby to form an upwardly narrowing mesa-type emitter region (142);
depositing a metal by using the second mask material (140) as a mask, thereby to form a base electrode (138) on the exposed second semiconductor layer;
removing the second mask material (140);
forming a third mask material after the step of removing the second mask material;
forming a collector electrode forming pattern on the third mask material and etching the first mask material (132);
etching the third semiconductor layer and the second semiconductor layer by using the first mask material as a mask, until the first semiconductor layer (112) is exposed;
depositing a second metal with use of the third mask material as a mask to form a collector electrode (134) on the exposed first semiconductor layer;
removing the third mask material;
forming a planarising resin layer (146) over the entire exposed surface of the resultant structure after the third mask is removed;
subjecting the formed resin layer to an etching, until the first mask material (132) is exposed;
removing the first mask material (132) exposed by the etching step to expose the third semiconductor layer (124); and
forming an emitter electrode (136) on the entire exposed third semiconductor layer.

11. The method according to claim 10,
characterized in that said resin layer is formed of polyimide.

12. The method according to claim 10,
characterized in that said first, second and third semiconductor layers are formed by an epitaxial growth method.

13. The method according to claim 10,
characterized in that, before the emitter electrode is formed, the semiconductor structure is subjected to a pretreatment using ammonium fluoride.

## Patentansprüche

1. Bipolartransistorvorrichtung mit:
einem Kollektorbereich (112, 116) eines ersten Leitfähigkeitstyps, der auf einem Halbleitersubstrat gebildet ist,
einem Basisbereich (118) eines zweiten Leitfähigkeitstyps, der auf dem Kollektorbereich gebildet ist,
einem nach oben schmäler werdenden Mesatyp-Emitterbereich (120, 122, 124) des ersten Leitfähigkeitstyps, der auf dem Basisbereich gebildet ist,
einer Basiselektrode (138), die auf dem Basisbereich gebildet und von einem Bodenteil des Mesatyp-Emitterbereiches getrennt ist,
einer Harzschicht (146), die auf der Basiselektrode gebildet ist und den Basisbereich, der zwischen der Basiselektrode und dem Elektrodenteil des Emitterbereiches freiliegt, und eine Seitenfläche des Emitterbereiches bedeckt, und
einer Emitterelektrode (136), die die gesamte Oberseite des Emitterbereiches bedeckt und an ihrem Endteil die Basiselektrode überlappt, wobei die Harzschicht dazwischengelegt ist.

2. Vorrichtung nach Anspruch 1, dadurch gekennzeichnet, daß die Harzschicht eine Polyimidharzschicht ist.

3. Vorrichtung nach Anspruch 1, dadurch gekennzeichnet, daß die Harzschicht in einer höheren Position als der Emitterbereich gebildet ist.

4. Vorrichtung nach Anspruch 1, dadurch gekennzeichnet, daß ein Abstand zwischen dem Bodenteil des Emitterbereiches und der Basiselektrode 0,05 bis 0,5 »m beträgt.

5. Bipolartransistorvorrichtung mit:
einem Kollektorbereich (112, 116) eines ersten Leitfähigkeitstyps, der auf einem Halbleitersubstrat gebildet ist,
einem Basisbereich (118) eines zweiten Leitfähigkeitstyps, der auf dem Kollektorbereich gebildet ist,
einem nach oben schmäler werdenden Mesatyp-Emitterbereich (120, 122, 124) des ersten Leitfähigkeitstyps, der auf dem Basisbereich gebildet ist,
einer Basiselektrode (138), die auf dem Basisbereich gebildet und von einem Bodenteil des Mesatyp-Emitterbereiches getrennt ist,
einer ersten Harzschicht (146), die auf der Basiselektrode gebildet ist und den Basisbereich, der zwischen der Basiselektrode und dem Bodenteil des Emitterbereiches freiliegt, und eine Seitenfläche des Emitterbereiches bedeckt.
einer Emitterelektrode (136), die die gesamte Oberseite des Emitterbereiches bedeckt und an ihrem Endteil die Basiselektrode überlappt, wobei die Harzschicht dazwischengelegt ist,
einer Kollektorelektrode (134), die auf dem Kollektorbereich gebildet ist, und
einer zweiten Harzschicht (146) der gleichen Art wie die erste Harzschicht, wobei die zweite Harzschicht auf der Kollektorelektrode vorgesehen ist.

6. Vorrichtung nach Anspruch 5, dadurch gekennzeichnet, daß die erste und die zweite Harzschicht auf der Basiselektrode und der Kollektorelektrode Polyimidharzschichten sind, und daß diese Harzschichten auf im wesentlichen dem gleichen Pegel gelegen sind.

7. Verfahren zum Herstellen einer Bipolartransistorvorrichtung, bei dem eine erste Halbleiterschicht (112, 116) eines ersten Leitfähigkeitstyps, eine zweite Halbleiterschicht (118) eines zweiten Leitfähigkeitstyps und eine dritte Halbleiterschicht (120, 122, 124) des ersten Leitfähigkeitstyps sequentiell auf ein Halbleitersubstrat geschichtet sind und bei dem eine Kollektorelektrode (134), eine Basiselektrode (138) und eine Emitterelektrode (136) jeweils auf der ersten bis dritten Halbleiterschicht gebildet sind, wobei das Verfahren die folgenden Schritte aufweist:
Bilden eines ersten Maskenmaterials (132) zum Bilden eines Emitterbereiches und eines zweiten Maskenmaterials (140) zum Bilden einer Basiselektrode auf der dritten Halbleiterschicht (120, 122, 124) in dieser Reihenfolge,
Bilden eines Basiselektrodenmusters auf dem zweiten Maskenmaterial und Bilden eines Musters, das weiter ist als das Basiselektrodenmuster, auf dem ersten Maskenmaterial,
Durchführen eines Ätzens, bis die zweite Halbleiterschicht (118) freiliegt, mittels des ersten Maskenmaterials als eine Maske, um so einen nach oben schmäler werdenden Mesatyp-Emitterbereich (142) zu bilden,
Ablagern eines Metalles mittels des zweiten Maskenmaterials als eine Maske, um so eine Basiselektrode (138) auf der freiliegenden zweiten Halbleiterschicht zu bilden,
Entfernen des zweiten Maskenmaterials (140),
Bilden einer planaren Harzschicht (146) über der gesamten freiliegenden Oberfläche der sich ergebenden Struktur, nachdem die zweite Maske entfernt ist,
Unterwerfen der gebildeten Harzschicht unter ein Ätzen, bis das erste Maskenmaterial (132) freiliegt,
Entfernen des durch den Ätzschritt freiliegenden ersten Maskenmaterials (132) und Freilegen der dritten Halbleiterschicht (124) und
Bilden einer Emitterelektrode (136) auf der gesamten freiliegenden dritten Halbleiterschicht.

8. Verfahren nach Anspruch 7, dadurch gekennzeichnet, daß die erste,. zweite und dritte Halbleiterschicht durch ein epitaxiales Wachstumsverfahren gebildet sind.

9. Verfahren nach Anspruch 7, dadurch gekennzeichnet, daß vor dem Bilden der Emitterelektrode die Halbleiterstruktur einer Vorbehandlung mittels Ammoniumfluorid unterworfen wird.

10. Verfahren zum Herstellen einer Bipolartransistorvorrichtung, bei dem eine erste Halbleiterschicht (112, 116) eines ersten Leitfähigkeitstyps, eine zweite Halbleiterschicht (118) eines zweiten Leitfähigkeitstyps und eine dritte Halbleiterschicht (120, 122, 124) des ersten Leitfähigkeitstyps sequentiell auf ein Halbleitersubstrat geschichtet werden und bei dem eine Kollektorelektrode (134), eine Basiselektrode (138) und eine Emitterelektrode (136) auf jeweils der ersten bis dritten Halbleiterschicht gebildet werden, wobei das Verfahren die folgenden Schritte aufweist:
Bilden eines ersten Maskenmaterials (132) zum Bilden eines Emitterbereiches und eines zweiten Maskenmaterials (140) zum Bilden einer Basiselektrode auf der dritten Halbleiterschicht (120, 122, 124) in dieser Reihenfolge,
Bilden eines Basiselektrodenmusters auf dem zweiten Maskenmaterial und Bilden eines Musters, das weiter ist als das Basiselektrodenmuster, auf dem ersten Maskenmaterial,
Durchführen eines Ätzens, bis die zweite Halbleiterschicht (118) freiliegt, indem das erste Maskenmaterial (132) als eine Maske verwendet wird, um so einen nach oben schmäler werdenden Mesatyp-Emitterbereich (142) zu bilden,
Ablagern eines Metalls mittels des zweiten Maskenmaterials (140), als eine Maske, um so eine Basiselektrode (138) auf der freiliegenden zweiten Halbleiterschicht zu bilden,
Entfernen des zweiten Maskenmaterials (140),
Bilden eines dritten Maskenmaterials nach dem Schritt des Entfernens des zweiten Maskenmaterials,
Bilden einer Kollektorelektrode, die ein Muster bildet, auf dem dritten Maskenmaterial und Ätzen des ersten Maskenmaterials (132),
Ätzen der dritten Halbleiterschicht und der zweiten Halbleiterschicht mittels des ersten Maskenmaterials als eine Maske, bis die erste Halbleiterschicht (112) freiliegt,
Auftragen eines zweiten Metalles mittels des dritten Maskenmaterials als eine Maske, um so eine Kollektorelektrode (134) auf der freiliegenden ersten Halbleiterschicht zu bilden,
Entfernen des dritten Maskenmaterials,
Bilden einer planaren Harzschicht (146) über der gesamten freiliegenden Oberfläche der sich ergebenden Struktur, nachdem die dritte Maske entfernt ist,
Unterwerfen der gebildeten Harzschicht unter ein Ätzen, bis das erste Maskenmaterial (132) freiliegt,
Entfernen des durch den Ätzschritt freiliegenden ersten Maskenmaterials (132), um die dritte Halbleiterschicht (124) freizulegen, und
Bilden einer Emitterelektrode (136) auf der gesamten freiliegenden dritten Halbleiterschicht.

11. Verfahren nach Anspruch 10, dadurch gekennzeichnet, daß die Harzschicht aus Polyimid gebildet wird.

12. Verfahren nach Anspruch 10, dadurch gekennzeichnet, daß die erste, zweite und dritte Halbleiterschicht durch ein epitaxiales Wachstumsverfahren gebildet werden.

13. Verfahren nach Anspruch 10, dadurch gekennzeichnet, daß vor dem Bilden der Emitterelektrode die Halbleiterstruktur einer Vorbehandlung mittels Ammoniumfluorid unterworfen wird.

## Revendications

1. Dispositif formant transistor bipolaire, comprenant:
- une région de collecteur (112, 116) d'un premier type de conductibilité formée sur un substrat de semiconducteur;
- une région de base (118) d'un deuxième type de conductiblité formée sur la région de collecteur;
- une région d'émetteur du type mésa à largeur diminuant vers le haut (120, 122, 124) du premier type de conductibilité formée sur la région de base;
- une électrode de base (138) formée sur la région de base et séparée d'une partie inférieure de la région d'émetteur du type mésa;
- une couche de résine (146) formée sur l'électrode de base et recouvrant la région de base exposée entre l'électrode de base et la partie inférieure de la région d'émetteur, et une face latérale de la région d'émetteur; et
- une électrode d'émetteur (136) recouvrant toute la surface supérieure de ladite région d'émetteur et chevauchant, au niveau de sa partie d'extrémité, l'électrode de base, avec la couche de résine interposée.

2. Dispositif selon la revendication 1, caractérisé en ce que ladite couche de résine est une couche de résine polyimide.

3. Dispositif selon la revendication 1, caractérisé en ce que ladite couche de résine est formée à une position plus haute que ladite région d'émetteur.

4. Dispositif selon la revendication 1, caractérisé en ce que la distance entre la partie inférieure de la région d'émetteur et l'électrode de base est de 0,05 à 0,5 »m.

5. Dispositif formant transistor bipolaire, comprenant:
- une région de collecteur (112, 116) d'un premier type de conductibilité formé sur un substrat de semiconducteur;
- une région de base (118) d'un deuxième type de conductiblité formée sur la région de collecteur;
- une région d'émetteur du type mésa à largeur diminuant vers le haut (120, 122, 124) du premier type de conductibilité formée sur la région de base;
- une électrode de base (138) formée sur la région de base et séparée d'une partie inférieure de la région d'émetteur du type mésa;
- une première couche de résine (146) formée sur l'électrode de base et recouvrant la région de base exposée entre l'électrode de base et la partie inférieure de la région d'émetteur, et une face latérale de la région d'émetteur;
- une électrode d'émetteur (136) recouvrant toute la surface supérieure de ladite région d'émetteur et chevauchant, au niveau de sa partie d'extrémité, l'électrode de base, avec la couche de résine interposée;
- une électrode de collecteur (134) formée sur la région de collecteur; et
- une deuxième couche de résine (146) du même type que la première couche de résine, la deuxième couche de résine étant formée sur l'électrode de collecteur.

6. Dispositif selon la revendication 5, caractérisé en ce que lesdites première et deuxième couches de résine formées sur l'électrode de base et l'électrode de collecteur sont des couches de résine polyimide et ces couches de résine sont situées sensiblement au même niveau.

7. Procédé de fabrication d'un dispositif formant transistor bipolaire, dans lequel une première couche de semiconducteur (112, 116) d'un premier type de conductibilité, une deuxième couche de semiconducteur (118) d'un deuxième type de conductibilité et une troisième couche de semiconducteur (120, 122, 124) du premier type de conductibilité sont formées successivement sur un substrat de semiconducteur, et une électrode de collecteur (134), une électrode de base (138) et une électrode d'émetteur (136) sont formées sur les première à troisième couches de semiconducteur, respectivement, ledit procédé comprenant les étapes consistant à:
- former une première matière de masque (132) pour former une région d'émetteur, et une deuxième matière de masque (140) pour former une électrode de base, sur la troisième couche de semiconducteur (120, 122, 124), dans cet ordre;
- former un motif d'électrode de base sur la deuxième matière de masque et former un motif plus large que le motif d'électrode de base sur la première matière de masque;
- exécuter une attaque chimique jusqu'à ce que la deuxième couche de semiconducteur (118) soit exposée en utilisant la première matière de masque comme masque, pour former par ce moyen une région d'émetteur du type mésa à largeur diminuant vers le haut (142);
- déposer un métal en utilisant la deuxième matière de masque comme masque pour former par ce moyen une électrode de base (138) sur la deuxième couche de semiconducteur exposée;
- éliminer la deuxième matière de masque (140);
- former une couche de résine planarisante (146) sur toute la surface exposée de la structure résultante après que la deuxième matière de masque a été éliminée;
- soumettre la couche de résine formée à une attaque chimique jusqu'à ce que la première matière de masque (132) soit exposée;
- éliminer la première matière de masque (132) exposée par l'étape d'attaque chimique et exposer la troisième couche de semiconducteur (124); et
- former une électrode d'émetteur (136) sur toute la troisième couche de semiconducteur exposée.

8. Procédé selon la revendication 7, caractérisé en ce que lesdites première, deuxième et troisième couches de semiconducteur sont formées par un procédé de croissance épitaxiale.

9. Procédé selon la revendication 7, caractérisé en ce que, avant que l'électrode d'émetteur soit formée, la structure de semiconducteur est soumise à un prétraitement utilisant du fluorure d'ammonium.

10. Procédé de fabrication d'un dispositif formant transistor bipolaire, dans lequel une première couche de semiconducteur (112, 116) d'un premier type de conductibilité, une deuxième couche de semiconducteur (118) d'un deuxième type de conductibilité et une troisième couche de semiconducteur (120, 122, 124) du premier type de conudctibilité sont formées successivement sur un substrat de semiconducteur, et une électrode de collecteur (134), une électrode de base (138) et une électrode d'émetteur (136) sont formées sur les première à troisième couches de semiconducteur, respectivement, ledit procédé comprenant les étapes consistant à:
- former une première matière de masque (132) pour former une région d'émetteur, et une deuxième matière de masque (140) pour former une électrode de base, sur la troisième couche de semiconducteur (120, 122, 124), dans cet ordre;
- former un motif d'électrode de base sur la deuxième matière de masque et former un motif plus large que le motif d'électrode de base sur la première matière de masque;
- exécuter une attaque chimique jusqu'à ce que la deuxième couche de semiconducteur (118) soit exposée en utilisant la première matière de masque (132) comme masque pour former par ce moyen une région d'émetteur (142) du type mésa à largeur diminuant vers le haut;
- déposer un métal en utilisant la deuxième matière de masque (140) comme masque pour former par ce moyen une électrode de base (138) sur la deuxième couche de semiconducteur exposée;
- éliminer la deuxième matière de masque (140);
- former une troisième matière de masque après l'étape d'élimination de la deuxième matière de masque;
- former un motif formant électrode de collecteur sur la troisième matière de masque et attaquer chimiquement la première matière de masque (132);
- attaquer chimiquement la troisième couche de semiconducteur et la deuxième couche de semiconducteur en utilisant la première matière de masque comme masque, jusqu'à ce que la première couche de semiconducteur (112) soit exposée;
- déposer un deuxième métal avec utilisation de la troisième matière de masque comme masque pour former une électrode de collecteur (134) sur la première couche de semiconducteur exposée;
- éliminer la troisième matière de masque;
- former une couche de résine planarisante (146) sur toute la surface exposée de la structure résultante après que la troisième matière de masque a été éliminée;
- soumettre la couche de résine formée à une attaque chimique jsuqu'à ce que la première matière de masque (132) soit exposée;
- éliminer la première matière de masque (132) exposée par l'étape d'attaque chimique pour exposer la troisième couche de semiconducteur (124); et
- former une électrode d'émetteur (136) sur toute la troisième couche de semiconducteur exposée.

11. Procédé selon la revendication 10, caractérisé en ce que ladite couche de résine est constituée de polyimide.

12. Procédé selon la revendication 10, caractérisé en ce que lesdites première, deuxième et troisième couches de semiconducteur sont formées par un procédé de croissance épitaxiale.

13. Procédé selon la revendication 10, caractérisé en ce que, avant que l'électrode d'émetteur soit formée, la structure de semiconducteur est soumise à un prétraitement utilisant du fluorure d'ammonium.
